# EUROPÄISCHE PATENTSCHRIFT

(11) **EP 1 415 271 B1**
(45) Veröffentlichungstag und Bekanntmachung des Hinweises auf die Patenterteilung: **26.10.2005**
(21) Anmeldenummer: 02754512.8
(22) Anmeldetag: 09.08.2002
(51) Int. Cl.: G06K 19/077, H01L 23/31

(54) **KONTAKTIERUNG VON HALBLEITERCHIPS IN CHIPKARTEN**
BONDING OF SEMICONDUCTOR CHIPS IN CHIP CARDS
ETABLISSEMENT DES CONTACTS DE PUCES SEMICONDUCTRICES DANS DES CARTES A PUCE

(30) Priorität: 10.08.2001 DE 10139395
(43) Veröffentlichungstag der Anmeldung: 06.05.2004
(73) Patentinhaber: Infineon Technologies AG, 81669 München (DE)
(72) Erfinder: HEINEMANN, Erik, 93049 Regensburg (DE); PUESCHNER, Frank, 93309 Kelheim (DE)
(74) Vertreter: Epping - Hermann - Fischer
(86) Internationale Anmeldenummer: PCT/DE2002/002935
(87) Internationale Veröffentlichungsnummer: WO 2003/017196

(56) Entgegenhaltungen:
- DE-A- 19 828 653
- FR-A- 2 786 009
- US-A- 6 031 724

## Beschreibung

Die Erfindung betrifft eine Chipkarte, die einen Chipkartenkörper, einen Halbleiterchip und ein an dem Chipkartenkörper befestigtes Trägersubstrat, mit dem der Halbleiterchip elektrisch und mechanisch verbunden ist, aufweist,
- wobei der Chipkartenkörper eine erste Kavität und eine zweite Kavität aufweist, wobei die zweite Kavität in den Boden der ersten Kavität eingelassen ist, so daß die erste Kavität sich seitlich über die zweite Kavität hinaus erstreckt und eine Bodenfläche der ersten Kavität die zweite Kavität umschließt,
- wobei das Trägersubstrat in der ersten Kavität angeordnet ist und auf seiner Oberseite obere Flächenkontakte zum Auslesen der Chipkarte und auf seiner Unterseite untere Flächenkontakte aufweist, die durch durch das Trägersubstrat verlaufende Kontaktlochleitungen (vias) miteinander elektrisch verbunden sind,
- wobei der Halbleiterchip durch elektrische Verbindungen mit den unteren Flächenkontakten des Trägersubstrats verbunden ist und
- wobei die Kontaktlochleitungen sowohl die unteren Flächenkontakte als auch die oberen Flächenkontakte durchstoßen und in dem Bereich der ersten Kavität, der sich seitlich außerhalb der zweiten Kavität erstreckt, angeordnet sind und die Kontaktlochleitungen am Boden der ersten Kavität abgedeckt sind.

Chipkarten bestehen im wesentlichen aus einem Chipkartenkörper, in der Regel einer Plastikkarte, die zur Unterbringung des Halbleiterchips einen Hohlraum aufweist. Dieser Hohlraum besteht üblicherweise aus einer äußeren, flachen Kavität, in deren Bodenfläche eine weitere, innere Kavität eingelassen ist. Die innere Kavität besitzt einen kleineren Flächenquerschnitt als die äußere Kavität, so daß sich die äußere Kavität seitlich über die innere Kavität hinaus erstreckt. Die Bodenfläche der äußeren Kavität umschließt die innere Kavität.

Die innere Kavität dient dazu, den Halbleiterchip in dem Chipkartenkörper unterzubringen. In der äußeren Kavität wird das Trägersubstrat angeordnet, mit dem der Halbleiterchip elektrisch und mechanisch verbunden ist. Die elektrischen Verbindungen des Halbleiterchips mit den Flächenkontakten auf der Oberseite des Trägersubstrats ermöglichen ein Auslesen der Karte und - je nach Chipkarte - ein Einschreiben von Informationen in den Halbleiterchip durch eine entsprechende Kontaktierung der oberen Flächenkontakte durch einen Chipkartenautomaten.

Das Trägersubstrat ist auf der Bodenfläche der äußeren Kavität befestigt und füllt die äußere Kavität fast vollständig aus. Das Trägersubstrat verdeckt gleichzeitig die innere Kavität, in der sich der Halbleiterchip befindet. Daher wird der Halbleiterchip durch das Trägersubstrat vor äußeren Einflüssen geschützt.

Es sind Chipkarten bekannt, deren Trägersubstrate dazu auf seiner Oberseite Flächenkontakte aufweisen, an deren Rückseiten Bondverbindungen, beispielsweise Bonddrähte befestigt sind, die den Halbleiterchip mit den Flächenkontakten elektrisch verbinden. Um die Bonddrähte mit den Rückseiten der Flächenkontakte auf der Oberseite des Trägersubstrats verbinden zu können, weist das Trägersubstrat unter jedem Kontakt eine Öffnung auf.

Aus dem Dokument US-A-6 031 724 sind Chipkarten bekannt, deren Trägersubstrat auch auf seiner Unterseite Flächenkontakte aufweist. Die Flächenkontakte sind mit dem Halbleiterchip wie auch mit den Flächenkontakten auf der Oberseite der Chipkarte elektrisch verbunden. Zur elektrischen Verbindung der oberen und der unteren Flächenkontakte miteinander sind in dem Trägersubstrat Kontaktlochleitungen, sogenannte vias gefertigt. Ein via ist eine vorzugsweise zylindrische Öffnung in dem Trägersubstrat, die einen Durchmesser zwischen 0,1 und 1 mm besitzt und sich von der Unterseite bis zur Oberseite des Trägersubstrats erstreckt, wobei das obere Ende des vias bzw. Kontaktlochleitung häufig durch die oberen Flächenkontakte abgedeckt ist. Die zylindrische Innenwandung der Kontaktlochleitungen ist so bearbeitet, daß sie elektrisch leitend ist. Aufgrund einer entsprechenden metallischen oder anderen elektrisch leitfähigen Belegung der Innenwandung stellt das Kontaktloch eine elektrische Leitung dar. Diese verläuft zwischen je einem oberen und einem unteren Flächenkontakt des Trägersubstrats.

Der Halbleiterchip ist durch elektrische Verbindungen mit den unteren Flächenkontakten des Trägersubstrats verbunden und daher über die Vias von der Oberseite des Trägersubstrats elektrisch ansteuerbar.

Ein in einer Chipkarte eingeschlossener Halbleiterchip muß gegen Umgebungseinflüsse isoliert werden, damit Feuchtigkeit oder in der Umgebungsluft enthaltene Schadstoffe nicht in den Halbleiterchip eindiffundieren. Um einen Kontakt des durch die zweite, innere Kavität gebildeten Innenraums mit der Umgebung zu verhindern, können die Vias, die das Trägersubstrat durchquerende Öffnungen sind, außerhalb der Grundfläche der zweiten Kavität auf der Bodenfläche der ersten Kavität angeordnet werden. Ein Austausch der Umgebungsluft mit der Luft im Innern der zweiten Kavität ist dadurch unterbunden.

Jedoch kann auch schon während des Herstellungsprozesses ein den Halbleiterchip langfristig schädigendes Mikroklima, das Feuchtigkeit und/oder Schadstoffe enthält, in der zweiten Kavität eingeschlossen werden. Eine Schädigung des Halbleiterchips durch dieses Mikroklima kann auch durch eine Abdeckmasse, die die dem Trägersubstrat zugewandte Oberseite der integrierten Schaltung bedeckt, nicht zuverlässig vermieden werden. In dem Mikroklima enthaltene Schadstoffe können durch die Abdeckmasse diffundieren oder durch Grenzflächen zwischen der Abdeckmasse und dem Halbleiterchip. Ein derartige Art der Abdeckung des Chips ist aus dem Dokument DE-A-198 28 653 bekannt.

Es ist die Aufgabe der vorliegenden Erfindung, eine Chipkarte bereitzustellen, bei der eine weitgehende Abschirmung des Halbleiterchips gegenüber Schadstoffen und Feuchtigkeit auch gegenüber dem in der zweiten Kavität eingeschlossenen Luftvolumen kostengünstig verwirklicht ist.

Diese Aufgabe wird erfindungsgemäß dadurch gelöst, daß das Trägersubstrat an seiner Unterseite durch eine Haftschicht, die sich von dem Boden der ersten Kavität aus in das Innere der zweiten Kavität hinein erstreckt und einen Bereich des Halbleiterchips bedeckt, an der Bodenfläche der ersten Kavität befestigt ist.

Erfindungsgemäß wird eine Abschirmung gegenüber dem größten Teil des Luftvolumens, das in der zweiten Kavität eingeschlossen ist, dadurch erreicht, daß eine Haftschicht, die bei der gattungsgemäßen Chipkarte zur Befestigung des Trägersubstrats an den Chipkartenkörper vorgesehen ist, auch in der zweiten Kavität vorgesehen wird. Herkömmlich ist die Haftschicht nur im Bereich der Bodenfläche der ersten Kavität außerhalb der zweiten Kavität angeordnet und besitzt im Bereich der zweiten Kavität eine Aussparung, da dort in Höhe der Bodenfläche der ersten Kavität die elektrischen Kontakte zum Halbleiterchip angeordnet sind. Erfindungsgemäß ist vorgesehen, daß sich die Haftschicht von dem Boden der ersten Kavität aus in das Innere der zweiten Kavität hinein erstreckt und einen Bereich des Halbleiterchips bedeckt. Dieselbe Haftschicht, die zum Befestigen des Trägersubstrats herkömmlich nur an der Bodenfläche außerhalb der zweiten Kavität vorgesehen ist, bedeckt somit erfindungsgemäß zugleich innerhalb der zweiten Kavität den Halbleiterchip an seiner Unterseite und erstreckt sich neben den Seitenflächen des Halbleiterchips bis zur Bodenfläche der ersten Kavität, wodurch das Luftvolumen der zweiten Kavität zweigeteilt wird. Die Haftschicht schirmt den größten Teil des Luftvolumens gegen den Halbleiterchip ab, so daß nur noch ein Bruchteil der enthaltenen Feuchtigkeit und/oder Schadstoffe mit dem Halbleiterchip in Kontakt kommt. Dadurch wird eine weitgehende Abschirmung des Mikroklimas erreicht, die ohne zusätzlichen Kostenaufwand realisiert ist. Insbesondere ist vorgesehen, daß die Haftschicht den Halbleiterchip in der zweiten Kavität von unten her umschließt. Da die Haftschicht den über die Unterseite des Trägersubstrats emporragenden Halbleiterchip umhüllt, stellt sie eine zusätzliche Schutzhülle dar.

Eine bevorzugte Ausführungsform sieht vor, daß der Halbleiterchip im Bereich seiner elektrischen Verbindungen zu den unteren Flächenkontakten des Trägersubstrats mit einer elektrisch isolierenden oder anisotrop leitfähigen Abdeckmasse bedeckt ist und daß die Haftschicht einen von der Abdeckmasse nicht abgedeckten Bereich des Halbleiterchips bedeckt. Aufgrund der erfindungsgemäßen, auf der Bodenfläche der äußeren Kavität stattfindenden Abdichtung des Volumens der inneren Kavität gegenüber den Hohlräumen in den Kontaktlochleitungen und gegenüber der äußeren Umgebung der Chipkarte ist das Volumen der inneren Kavität klimatisch abgeschirmt. Kommt es jedoch aufgrund starker mechanischer Beanspruchung des Chipkartenkörpers zu Undichtigkeiten und infolgedessen zu einem Eindringen von Feuchtigkeit in die innere Kavität, so schützt die Abdeckmasse die elektrischen Verbindungen zwischen dem Halbleiterchip und den unteren Flächenkontakten vor einer Korrosion. Fierzu kann ferner auch eine anisotrop leitfähige Abdeckmasse (anisotropic conductive paste) oder ein anisotrop leitfähiges Klebeband (anisotropic conducttive adhesive) verwendet werden.

Werden die Kontaktlochleitungen in dem Bereich der ersten Kavität angeordnet, der sich seitlich außerhalb der zweiten Kavität erstreckt, so münden die Kontaktlochleitungen in die Bodenfläche der ersten Kavität; dort werden die Kontaktlochleitungen automatisch verschlossen. Aufgrund dieser Position der Kontaktlochleitungen ist es nicht mehr erforderlich, zum Schutz des Halbleiterchips Abdeckungen für die Kontaktlochleitungen anzubringen, da diese nicht mehr in das Innere der zweiten Kavität führen. Die so geschaffene Chipkarte ist kostengünstig herzustellen und schützt den Halbleiterchip vor äußeren klimatischen Einflüssen, so daß ein für den Halbleiterchip schädliches Mikroklima nicht entstehen kann.

Vorzugsweise ist vorgesehen, daß die Kontaktlochleitungen durch die Haftschicht verschlossen sind. In diesem Fall enden die Kontaktlochleitungen am Boden der ersten, äußeren Kavität des Chipkartenkörpers aufgebrachten Haftschicht, die das Trägersubstrat hält. Die Haftschicht, die die Bodenfläche der äußeren Kavität bedeckt, deckt den Rand der Unterseite des Trägersubstrats und dadurch gleichzeitig die unteren Öffnungen der am Rand des Trägersubstrats angeordneten Kontaktlochleitungen ab.

Alternativ ist vorgesehen, daß die Kontaktlochleitungen in Ausnehmungen der Haftschicht münden und daß die Haftschicht durch die Ausnehmungen gebildete Hohlräume umschließt und abdichtet. Hierbei sind in der Haftschicht des Chipkartenkörpers Ausnehmungen vorgesehen, die in derselben seitlichen Position wie die Kontaktlochleitungen des Trägersubstrats angeordnet sind. Die unteren Öffnungen der Kontaktlochleitungen kommen hierbei nicht unmittelbar mit der Haftschicht in Berührung; statt dessen sind sie um die Dicke der Haftschicht beabstandet zur Bodenfläche der äußeren Kavität des Chipkartenkörpers angeordnet. Dies kann vorteilhaft sein, wenn die Oberfläche der unteren Flächenkontakte aufgrund der Fertigung der Kontaktlochleitungen leicht erhöht ist, beispielsweise wenn die Öffnung der Kontaktlochleitung von einer ringförmigen Erhebung umgeben ist. Da das Ende der Kontaktlochleitung in einen Hohlraum mündet, wird eine solche Erhebung von dem Boden der äußeren Kavität nicht direkt berührt und behindert daher nicht den Kontakt zwischen dem Trägersubstrat und der Haftschicht.

Vorzugsweise ist vorgesehen, daß die unteren Flächenkontakte des Trägersubstrats sich über den Innenrand der Bodenfläche der ersten Kavität hinaus bis über den Halbleiterchip innerhalb der zweiten Kavität erstrecken. Hierbei können die Anschlüsse des Halbleiterchips vertikal, d.h. senkrecht zur Fläche des Chipkartenkörpers, weisende Kontaktstifte sein, bis zu denen sich in lateraler Richtung die Kontaktflächen auf der Unterseite des Trägersubstrats erstrecken. Werden die im Bereich dieser Kontaktstifte angeordneten inneren Enden der unteren Flächenkontakte großzügig dimensioniert, so wird der Halbleiterchip auch bei einem geringfügigen lateralen Versatz sicher kontaktiert.

Einer bevorzugten Ausführungsform entsprechend ist der Halbleiterchip nach dem flip-chip-Verfahren auf die unteren Flächenkontakte des Trägersubstrats gebondet. Bei dem flip-chip-Verfahren wird der Halbleiterchip um 180 Grad, d. h. auf Kopf gedreht von unten mit dem Trägersubstrat verbunden in den Chipkartenkörper eingebaut. Dabei ist die nicht kontaktierte Oberseite des Halbleiterchips dem Boden der zweiten, inneren Kavität zugewandt und durch diesen von der nicht mit elektrischen Kontakten versehenen Kartenunterseite her geschützt.

Hinsichtlich des Materials der Haftschicht sehen bevorzugte Ausführungsformen vor, daß die Haftschicht aus einem Material, das erst bei erhöhter Temperatur klebend wird, oder aus einem gehärteten Flüssigklebstoff, vorzugsweise aus gehärtetem Cyanoacrylat ausgebildet ist. Eine Haftschicht aus einem erst bei erhöhter Temperatur klebenden Material hat den Vorteil, daß in kaltem, noch nicht klebenden Zustand leicht Ausnehmungen in die Haftschicht gestanzt werden können, in die später die unteren Enden der Kontaktlochleitungen münden. Bei einem Flüssigklebstoff kann hingegen auch das Innere der Kontaktlochleitungen teilweise gefüllt werden und dadurch eine größere Dichtungsfläche erreicht werden.

Die erfindungsgemäß ausgebildete Chipkarte ist vorzugsweise eine Mobilfunkkarte.

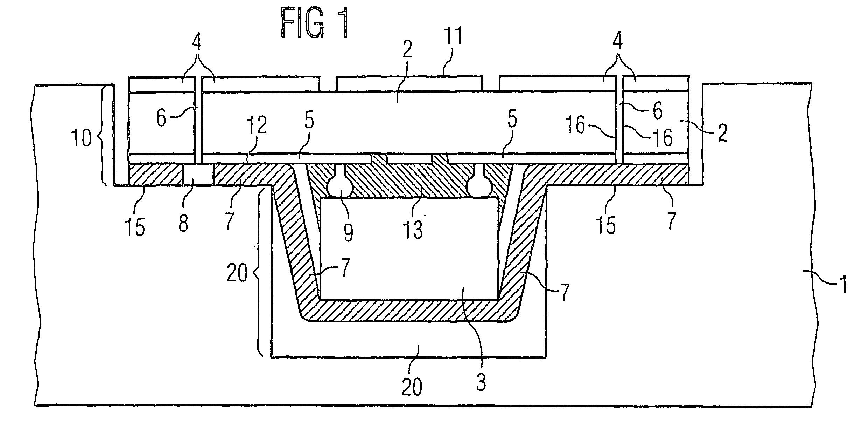

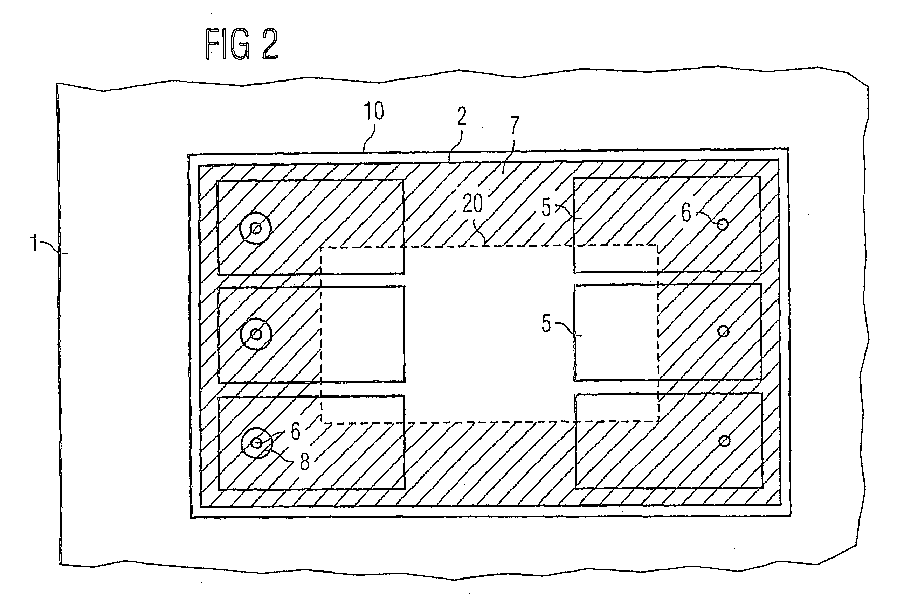

Die Erfindung wird nachstehend anhand der Figuren 1 und 2 be schrieben. Es zeigen:
- Figur 1: einen Querschnitt durch eine erfindungsgemäße Chip- karte und
- Figur 2: eine Draufsicht auf einen Ausschnitt der Oberseite einer erfindungsgemäßen Chipkarte.

Figur 1 zeigt einen Chipkartenkörper 1, der aus einem flexiblen oder auch starren Kunststoff bestehen kann, im Querschnitt, wobei die Dicke der Chipkarte der Höhe des in Figur 1 dargestellten Chipkartenkörpers 1 entspricht. Der Chipkartenkörper 1 weist eine äußere Kavität 10 auf, die in lateraler Richtung, d. h. parallel zur Chipkartenfläche, einen größeren Querschnitt besitzt als eine weitere Kavität 20, die in den Boden 15 der äußeren Kavität eingelassen ist. Die äußere Kavität 10 erstreckt sich seitlich nach links und rechts sowie senkrecht zur Zeichenebene nach oben und unten über die innere Kavität 20 hinaus, so daß die Bodenfläche 15 den Querschnitt der inneren Kavität umgibt. In der äußeren Kavität 10 ist ein Trägersubstrat 2 angeordnet. In der inneren Kavität 20 ist ein Halbleiterchip 3 angeordnet, der durch elektrische Verbindungen 9 mit dem Trägersubstrat 2 verbunden ist. Das Trägersubstrat 2 liegt über eine Haftschicht 7 auf der Bodenfläche 15 der äußeren Kavität 10 auf und ist auf diese Weise an dem Chipkartenkörper 1 befestigt. Das Trägersubstrat 2 dient erstens dazu, den Halbleiterchip 3 ohne unmittelbare Berührung mit dem möglicherweise flexiblen Chipkartenkörper 1 zu tragen, und zweitens dazu, den Halbleiterchip 3 zum Auslesen der Chipkarte elektrisch zu kontaktieren. Zu diesem Zweck sind auf der Oberseite 11 des Trägersubstrats mehrere Flächenkontakte 4 angeordnet. Das Trägersubstrat 2 weist auf seiner Unterseite 12 weitere Flächenkontakte 5 auf, die einen anderen Flächenquerschnitt als die oberen Flächenkontakte 4 besitzen. Sie erstrecken sich insbesondere mehr zur Mitte des Trägersubstrats hin als die oberen Flächenkontakte 4. Das Trägersubstrat 2 können im Zentrum der Oberseite 11 und der Unterseite 12 kontaktähnliche Flächen, sogenannte Inseln besitzen, die selbst nicht zum Kontaktieren des Halbleitersubstrats dienen. Der Halbleiterchip 3 ist durch elektrische Verbindungen 9 mit den Flächenkontakten 5 auf der Unterseite 12 des Trägersubstrats 2 verbunden. Die elektrische Verbindung zwischen den unteren Flächenkontakten 5 und den Flächenkontakten 4 auf der Oberseite 11 des Halbleiterchips, wo Kontakte eines Kartenautomats zum Lesen der Chipkarte aufsetzen, wird durch sogenannte vias 6 hergestellt. Ein via ist, wie in Figur 1 dargestellt, eine Bohrung in der Fläche eines Trägersubstrats 2, die die Oberseite 11 mit der Unterseite 12 verbindet. In Figur 1 werden obere Flächenkontakte 4 und untere Flächenkontakte 5 durch ein entsprechendes via 6 durchbohrt. Das via kann diese Kontakte innerhalb ihrer Kontaktfläche oder auch am Rand durchstoßen. Die in Figur 1 dargestellten, mit 4 bzw. 5 bezeichneten und durch vias 6 getrennten Bereiche zeigen jeweils Teile ein- und desselben Flächenkontakts, so daß Figur 1 insgesamt je zwei obere 4 und zwei untere Flächenkontakte 5 abbildet.

Ein via stellt einen Hohlkanal in der Masse des Trägersubstrats 2 dar, durch den Außenluft in das Innere der Chipkarte eindringen kann. Die Wandungen 16 der vias 6 sind so bearbeitet, daß sie elektrisch leitfähig sind. Sie weisen eine Bedeckung aus einem elektrisch leitfähigen Material auf, das wie die Wandung in Form eines Hohlzylinders ausgeformt ist. Infolge der leitfähigen Deckschicht stellt das via eine Kontaktlochleitung 6 dar. Das Innere der Kontaktlochleitung 6 ist hohl und ermöglicht, sofern die Kontaktlochleitung 6 nicht auf zumindest einer Seite des Trägersubstrats 2 abgedeckt wird, den klimatischen Austausch von Umgebungsluft und dem Volumen im Inneren des Kartengehäuses 2.

Die Kontaktlochleitungen 6 müssen nicht notwendigerweise ganz in der Querschnittsfläche eines Flächenkontaktes liegen; sie können ebenso am Rand eines Flächenkontaktes 4 bzw. 5, beispielsweise and Rand des Trägersubstrats 2 angeordnet sein.

Der in der inneren Kavität 20 angeordnete Halbleiterchip 3 ist durch die elektrischen Verbindungen 9, die unteren Flächenkontakte 5 und die Kontaktlochleitungen 6 mit den oberen Flächenkontakten 4 des Trägersubstrats 2 verbunden. Da die oberen Flächenkontakte 4 sich bis über die innere Kavität 20 erstrecken, können die Kontaktlochleitungen 6 innerhalb der Querschnittsfläche, d. h. in Figur 1 innerhalb der Breite der inneren Kavität 20, angeordnet sein. In diesem Fall müßten die unteren Flächenkontakte 5 lediglich einen kurzen lateralen Abstand zwischen den Kontaktlochleitungen 6 und den elektrischen Verbindungen 9 des Halbleiterchips 3 überbrücken. Bei einer solchen Anordnung der Kontaktlochleitungen 6 könnte Außenluft in die innere Kavität 20 gelangen und so ein für den Halbleiterchip 3 schädliches Mikroklima erzeugen. Insbesondere Feuchtigkeit und in der Luft enthaltene Schadstoffe können durch das Gehäusematerial 3 des Halbleiterchips diffundieren und diesen schädigen, sofern die Kontaktlochleitungen nicht gefüllt oder abgedeckt werden.

Herkömmliche Chipkarten mit Trägersubstraten, die beidseitig mit Flächenkontakten versehen sind, weisen sogenannte blind vias auf, die auf der Oberseite 11 des Trägersubstrats 2 durch nach der Ausbildung der Kontaktlochleitungen 6 aufgebrachte Flächenkontakte 4 abgedeckt und verschlossen sind. Diese Kontaktlochleitungen erstrecken sich daher nur bis zur Unterseite der metallischen Flächenkontakte 4, d. h. nur bis dicht unter die Oberseite des Trägersubstrats 2. Daher müssen die oberen Kontaktflächen 4 nach Fertigung der Kontaktlochleitungen aufgebracht werden, was die Herstellung des Trägersubstrats und damit der Chipkarte verteuert.

Erfindungsgemäß werden die Kontaktlochleitungen 6 in dem Bereich der äußeren Kavität 10 angeordnet, der sich seitlich außerhalb der inneren Kavität 20 erstreckt, so daß die Kontaktlochleitungen 6 seitlich versetzt zur inneren Kavität 20 in den Boden 15 der äußeren Kavität münden und dort abgedeckt sind, ohne daß es dazu eigener Hilfsmittel bedarf. Die erfindungsgemäße Chipkarte schützt dadurch den Halbleiterchip 3 vor einem schädlichen Mikroklima und ist zudem kostengünstig herzustellen.

Die Kontaktlochleitungen 6 können an ihren unteren Enden auf unterschiedliche Weise verschlossen werden. In Figur 1 sind diesbezüglich zwei bevorzugte Ausführungsformen dargestellt. Das in Figur 1 rechts dargestellte via 6 wird durch die Haftschicht 7, durch die das Trägersubstrat 2 am Boden 15 der äußeren Kavität 10 an dem Chipkartenkörper 1 befestigt ist, verschlossen. Das in Figur 1 links dargestellte via 6 ist entsprechend einer alternativen Ausführungsform von einer Ausnehmung 8 der Haftschicht 7 umgeben. Die Haftschicht 7 umschließt den durch die Ausnehmung 8 gebildeten Hohlraum in der Ebene der Bodenfläche 15 der äußeren Kavität 10 von allen Seiten und dichtet den Hohlraum in dieser Ebene nach allen Seiten ab. Durch das via 6 in den Hohlraum 8 gelangte Außenluft kann daher nicht in den Bereich der inneren Kavität 20 vordringen. Der Halbleiterchip 3 ist durch elektrische Verbindungen 9 mit den unteren Flächenkontakten 5 des Trägersubstrats 2 verbunden. Die an dem Halbleiterchip 3 montierten Anschlüsse 9 (bumb) können auf die Kontakte 5 gebondet sein oder, wenn wie abgebildet eine Abdeckmasse 13 auf die Kontakte 5 aufgebracht wird, auch dadurch elektrisch mit diesen Kontakten verbunden werden, daß der Halbleiterchip 3 so lange auf das Trägersubstrat 2 gedrückt wird, bis die Abdeckmasse 13 fest geworden ist und die Chipkontakte 9 sicher und dauerhaft auf den Flächenkontakten 5 hält. Die Klebemasse 13 kann vor dem Aufdrücken des Halbleiterchips 3 bereits auf die Flächenkontakte 5 aufgebracht sein, in welchem Fall die eingetauchten Kontakte 9 durch die Abdeckmasse 13 gedrückt werden.

Der nach dem flip-chip-Verfahren, d. h. über Kopf an dem Trägersubstrat 2 befestigte Halbleiterchip 3 und das Substrat 2 bilden zusammen das Modul der Chipkarte. Das Trägersubstrat 2 ist vorzugsweise eine flexible Leiterplatte, die aus einem Grundmaterial besteht, an dessen beiden Seiten 11, 12 Flächenkontakte 4, 5 aufgebracht sind. Das aus dem Grundmaterial und den beidseitigen Flächenkontakten gebildete mehrlagige Substrat wird vollständig von den Kontaktlochleitungen 6 durchbohrt, so daß das Trägersubstrat 2 selbst das Eindringen von Feuchtigkeit in die innere Kavität 20 und damit das Entstehen von Chipausfällen nicht verhindern kann.

Zur Befestigung des Kartenmoduls 2, 3 an dem Chipkartenkörper 1 dient die Schicht 7, die beispielsweise aus einem Kunststoff (hotmelt) bestehen kann, der bei hohen Temperaturen klebend wird. Ebenso können ein flüssiger Heißkleber oder alternativ schnell aushärtende Kunststoffe wie beispielsweise Cyanoacrylat verwendet werden.

Die Haftschicht 7 ist in Figur 1 erfindungsgemäß durchgehend dargestellt, d. h. sie erstreckt sich auch in die innere Kavität 20 hinein und umschließt dort den Halbleiterchip 3 von unten her. Dadurch wird der Chip 3 zusätzlich geschützt, wodurch der Halbleiterchip gegen einen Großteil des in der zweiten Kavität enthaltenen Luftvolumens abgeschirmt wird. Ein schädliches Mikroklima kann sich daher nur in wesentlich geringerem Ausmaß auf den Halbleiterchip auswirken als bei einer herkömmlichen Chipkarte. Zudem ist die erreichte Abschirmung kostengünstig realisiert.

Figur 2 zeigt einen Ausschnitt einer erfindungsgemäßen Chipkarte in schematischer Darstellung. In einer auf dem Chipkartenkörper 1 befindlichen äußeren Kavität 10 ist eine noch weiter in die Tiefe des Chipkartenkörpers 1 gehende innere Kavität 20 eingelassen, in der sich der Halbleiterchip 3 befindet. In der oberen Kavität 10, die sich seitlich über die innere Kavität 20 hinaus erstreckt, ist das Trägersubstrat 2 angeordnet. Zwischen der Unterseite des Trägersubstrats 2 und dem Boden der äußeren Kavität 10 ist die schraffiert dargestellte Haftschicht 7 angeordnet, die sich nur in den Bereichen der äußeren Kavität 10, die sich seitlich außerhalb des gestrichelt umrandeten Querschnitts der inneren Kavität 20 befinden, angeordnet.

In diese Haftschicht münden drei in Figur 2 auf der rechten Seite des Trägersubstrats 2 dargestellte Kontaktlochleitungen 6 und werden durch diese verschlossen. In einer alternativen Ausführungsart können die Kontaktlochleitungen 6 in Ausnehmungen 8 in der Haftschicht 7 münden, wobei auch in diesem Fall eine vollständige Abdichtung erzielt wird, da in der Ebene der Bodenfläche der ersten Kavität 10 die Haftschicht 7 die Ausnehmung 8 von allen Seiten umgibt und nach allen Seiten abdichtet. Ferner umschließt die Haftschicht 7 ebenso wie die Bodenfläche der ersten, äußeren Kavität 10 die innere Kavität 20 von allen Seiten und verhindert dadurch einen klimatischen Austausch von Umgebungsluft.

Bezugszeichenliste
- 1: Chipkartenkörper
- 2: Trägersubstrat
- 3: Halbleiterchip
- 4: oberer Flächenkontakt
- 5: unterer Flächenkontakt
- 6: Kontaktlochleitung (via)
- 7: Haftschicht
- 8: Ausnehmung
- 9: Chipkontakt (bump)
- 10: erste Kavität
- 11: Oberseite des Trägersubstrats
- 12: Unterseite des Trägersubstrats
- 13: Abdeckmasse
- 15: Bodenfläche der ersten Kavität
- 20: zweite Kavität

## Patentansprüche

1. Chipkarte, die einen Chipkartenkörper (1), einen Halbleiterchip (3) und ein an dem Chipkartenkörper (1) befestigtes Trägersubstrat (2), mit dem der Halbleiterchip (3) elektrisch und mechanisch verbunden ist, aufweist,
- wobei der Chipkartenkörper (1) eine erste Kavität (10) und eine zweite Kavität (20) aufweist, wobei die zweite Kavität (20) in den Boden der ersten Kavität (10) eingelassen ist, so daß die erste Kavität (10) sich seitlich über die zweite Kavität (20) hinaus erstreckt und eine Bodenfläche (15) der ersten Kavität (10) die zweite Kavität (20) umschließt,
- wobei das Trägersubstrat (2) in der ersten Kavität (10) angeordnet ist und auf seiner Oberseite (11) obere Flächenkontakte (4) zum Auslesen der Chipkarte und auf seiner Unterseite (12) untere Flächenkontakte (5) aufweist, die durch durch das Trägersubstrat (2) verlaufende Kontaktlochleitungen (6) miteinander elektrisch verbunden sind,
- wobei der Halbleiterchip (3) durch elektrische Verbindungen (9) mit den unteren Flächenkontakten (5) des Trägersubstrats (2) verbunden ist,
- wobei die Kontaktlochleitungen (6) sowohl die unteren Flächenkontakte (5) als auch die oberen Flächenkontakte (4) durchstoßen und in dem Bereich der ersten Kavität (10), der sich seitlich außerhalb der zweiten Kavität (20) erstreckt, angeordnet sind und die Kontaktlochleitungen (6) am Boden der ersten Kavität (10) abgedeckt sind und
- wobei das Trägersubstrat (2) an seiner Unterseite (12) durch eine Haftschicht (7), die sich von dem Boden der ersten Kavität (10) aus in das Innere der zweiten Kavität (20) hinein erstreckt und einen Bereich des Halbleiterchips (3) bedeckt, an der Bodenfläche (15) der ersten Kavität (10) befestigt ist.

2. Chipkarte nach einem Anspruch 1,
**dadurch gekennzeichnet, daß**
die Haftschicht (7) den Halbleiterchip (3) in der zweiten Kavität (20) von unten her umschließt.

3. Chipkarte nach Anspruch 1 oder 2,
**dadurch gekennzeichnet, daß**
der Halbleiterchip (3) im Bereich seiner elektrischen Verbindungen (9) zu den unteren Flächenkontakten (5) des Trägersubstrats (2) mit einer elektrisch isolierenden oder anisotrop leitfähigen Abdeckmasse (13) bedeckt ist und daß die Haftschicht (7) einen von der Abdeckmasse (13) nicht abgedeckten Bereich des Halbleiterchips (3) bedeckt.

4. Chipkarte nach einem der Ansprüche 1 bis 3,
**dadurch gekennzeichnet, daß**
daß die Kontaktlochleitungen (6) durch die Haftschicht (7) verschlossen sind.

5. Chipkarte nach einem der Ansprüche 1 bis 3,
**dadurch gekennzeichnet, daß**
die Kontaktlochleitungen (6) in Ausnehmungen (8) der Haftschicht (7) münden und daß die Haftschicht (7) die durch die Ausnehmungen (8) gebildeten Hohlräume umschließt und abdichtet.

6. Chipkarte nach einem der Ansprüche 1 bis 5,
**dadurch gekennzeichnet, daß**
die unteren Flächenkontakte (6) des Trägersubstrats (2) sich über den Innenrand der Bodenfläche (15) der ersten Kavität (10) hinaus bis über den Halbleiterchip (3) innerhalb der zweiten Kavität (20) erstrecken.

7. Chipkarte nach einem der Ansprüche 1 bis 6,
**dadurch gekennzeichnet, daß**
der Halbleiterchip (3) nach dem flip-chip-Verfahren auf die unteren Flächenkontakte (5) des Trägersubstrats (2) gebondet ist.

8. Chipkarte nach einem der Ansprüche 1 bis 7,
**dadurch gekennzeichnet, daß**
die Haftschicht (7) aus einem Material ausgebildet ist, das erst bei erhöhter Temperatur klebend wird.

9. Chipkarte nach einem der Ansprüche 1 bis 7,
**dadurch gekennzeichnet, daß**
die Haftschicht (7) aus einem gehärteten Flüssigklebstoff, vorzugsweise aus gehärtetem Cyanoacrylat ausgebildet ist.

10. Chipkarte nach einem der Ansprüche 1 bis 9,
**dadurch gekennzeichnet, daß**
die Chipkarte eine Mobilfunkkarte ist.

## Claims

1. Chip card, which has a chip card body (1), a semiconductor chip (3) and a carrier substrate (2), which is secured to the chip card body (1) and to which the semiconductor chip (3) is electrically and mechanically connected,
- the chip card body (1) having a first cavity (10) and a second cavity (20), the second cavity (20) being recessed into the base of the first cavity (10), so that the first cavity (10) extends laterally beyond the second cavity (20) and a base surface (15) of the first cavity (10) surrounds the second cavity (20),
- the carrier substrate (2) being arranged in the first cavity (10) and having upper surface contacts (4) for reading the chip card on its top side (11) and lower surface contacts (5) on its underside (12), which are electrically connected to one another by contact-hole lines (6) which run through the carrier substrate,
- the semiconductor chip (3) being connected to the lower surface contacts (5) of the carrier substrate (2) by electrical connections (9),
- the contact-hole lines (6) passing through both the lower surface contacts (5) and the upper surface contacts (5) and being arranged in the region of the first cavity (10) which extends laterally outside the second cavity (20), and the contact-hole lines (6) being covered at the base of the first cavity (10), and
- the carrier substrate (2), on its underside (12), being secured to the base surface (15) of the first cavity (10) by an adhesive layer (7) which extends from the base of the first cavity (10) into the interior of the second cavity (20) and covers a region of the semiconductor chip (3).

2. Chip card according to Claim 1, **characterized in that** the adhesive layer (7) surrounds the semiconductor chip (3) in the second cavity (20) from below.

3. Chip card according to Claim 1 or 2, **characterized in that** the semiconductor chip (3), in the region of its electrical connections (9) to the lower surface contacts (5) of the carrier substrate (2), is covered by an electrically insulating or anisotropically conductive paste (13), and **in that** the adhesive layer (7) covers a region of the semiconductor chip (3) which is not covered by the paste (13).

4. Chip card according to one of Claims 1 to 3, **characterized in that** the contact-hole lines (6) are closed off by the adhesive layer (7).

5. Chip card according to one of Claims 1 to 3, **characterized in that** the contact-hole lines (6) open out into recesses (8) in the adhesive layer (7), and **in that** the adhesive layer (7) surrounds and seals the spaces formed by the recesses (8).

6. Chip card according to one of Claims 1 to 5, **characterized in that** the lower surface contacts (6) of the carrier substrate (2) extend beyond the inner edge of the base surface (15) of the first cavity (10), as far as over the semiconductor chip (3) within the second cavity (20).

7. Chip card according to one of Claims 1 to 6, **characterized in that** the semiconductor chip (3) is bonded to the lower surface contacts (5) of the carrier substrate (2) using the flip-chip method.

8. Chip card according to one of Claims 1 to 7, **characterized in that** the adhesive layer (7) is formed from a material which only becomes adhesive at elevated temperature.

9. Chip card according to one of Claims 1 to 7, **characterized in that** the adhesive layer (7) is formed from a cured liquid adhesive, preferably from cured cyanoacrylate.

10. Chip card according to one of Claims 1 to 9, **characterized in that** the chip card is a mobile communication card.

## Revendications

1. Carte à puce qui comprend un corps (1) de carte à puce, une puce (3) à semi-conducteur et un substrat (2) de support qui est fixé au corps (1) de la carte à puce et qui est relié électriquement et mécaniquement à la puce (3) à semi-conducteur,
- dans laquelle le corps (1) de la carte à puce a une première cavité (10) et une deuxième cavité (20), la deuxième cavité (20) étant ménagée dans le fond de la première cavité (10), de sorte que la première cavité (10) s'étend latéralement au-delà de la deuxième cavité (20), et une surface (15) du fond de la première cavité (10) entoure la deuxième cavité (20),
- dans laquelle le substrat (2) de support est disposé dans la première cavité (10) et a, sur sa face (11) supérieure, des contacts (4) de surface supérieure pour la lecture de la carte à puce et, sur sa face (12) inférieure, des contacts (5) de surface inférieure qui sont reliés entre eux électriquement par des lignes (6) à trous de contact passant à travers le substrat (2) de support,
- dans laquelle la puce (3) à semi-conducteur est reliée par des liaisons (9) électriques aux contacts (5) de surface inférieure du substrat (2) de support,
- dans laquelle les lignes (6) de trous de contact traversent à la fois les contacts (5) de surface inférieure et les contacts (4) de surface supérieure et sont disposées dans la zone de la première cavité (10) qui s'étend latéralement en dehors de la deuxième cavité (20), et les lignes (6) de trous de contact sont recouvertes sur le fond de la première cavité (10) et
- dans laquelle le substrat (2) de support est fixé sur sa face (12) inférieure par une couche (16) adhésive qui s'étend du fond de la première cavité (10) à l'intérieur de la deuxième cavité (20) et qui recouvre une zone de la puce (3) à semi-conducteur à la surface (15) de fond de la première cavité (10).

2. Carte à puce suivant la revendication 1,
**caractérisée en ce que** la couche (7) adhésive entoure par le bas la puce (3) à semi-conducteur dans la deuxième cavité (20).

3. Carte à puce suivant la revendication 1 ou 2,
**caractérisée en ce que** la puce (3) à semi-conducteur est revêtue, dans la zone de ses liaisons (9) électriques avec les contacts (5) de surface inférieure du substrat (2) de support, d'une composition (13) de revêtement isolante électriquement ou conductrice de façon anisotrope, et **en ce que** la couche (7) adhésive revêt une zone de la puce (3) à semi-conducteur, qui n'est pas revêtue de la composition (13) de revêtement.

4. Carte à puce suivant l'une des revendications 1 à 3,
**caractérisée en ce que** les lignes (6) à trous de contact sont scellées par la couche (7) adhésive.

5. Carte à puce suivant l'une des revendications 1 à 3,
**caractérisée en ce que** les lignes (6) à trous de contact débouchent dans des évidements (8) de la couche (7) adhésive, et **en ce que** la couche (7) adhésive entoure les espaces vides formés par les évidements (8) et les rend étanches.

6. Carte à puce suivant l'une des revendications 1 à 5,
**caractérisée en ce que** les contacts (6) de surface inférieure du substrat (2) de support s'étendent au-delà du bord intérieur de la surface (15) de fond de la première cavité (10) jusqu'au-delà de la puce (3) à semi-conducteur à l'intérieur de la deuxième cavité (20).

7. Carte à puce suivant l'une des revendications 1 à 6,
**caractérisée en ce que** la puce (3) à semi-conducteur est liée par le procédé flip-chip aux contacts (5) de surface inférieure du substrat (2) support.

8. Carte à puce suivant l'une des revendications 1 à 7,
**caractérisée en ce que** la couche (7) adhésive est en une matière qui ne devient collante qu'à température élevée.

9. Carte à puce suivant l'une des revendications 1 à 7,
**caractérisée en ce que** la couche (7) adhésive est en une colle liquide durcie, de préférence en cyanoacrylate durci.

10. Carte à puce suivant l'une des revendications 1 à 9,
**caractérisée en ce que** la carte à puce est une carte de téléphonie mobile.
